# EUROPEAN PATENT APPLICATION

(11) **EP 3 073 565 A1**
(43) Date of publication of application: **28.09.2016**
(21) Application number: 14795505.8
(22) Date of filing: 15.05.2014
(51) Int. Cl.: H01Q 1/22, H01Q 1/36, H05K 3/02

(54) **DATA CARD ANTENNA AND CONSTRUCTION METHOD THEREOF**

(30) Priority: 20.11.2013 CN 201310589471
(71) Applicant: ZTE Corporation, Shenzhen, Guangdong 518057 (CN)
(72) Inventor: ZHOU, Chuangzhu, Shenzhen Guangdong 518057 (CN)
(74) Representative: Mozzi, Matteo
(86) International application number: PCT/CN2014/077605
(87) International publication number: WO 2014/180365

(57) **Abstract**

The disclosure discloses a data card antenna, comprising a Universal Serial Bus (USB) connector and a Printed Circuit Board (PCB), wherein a semi-closed gap is provided at one end of the PCB close to the USB connector, a feeding point and a metal radiator covering the semi-closed gap and electrically connected to the feeding point are provided in the semi-closed gap. The disclosure can reduce space occupied by an antenna, improve bandwidth of the antenna and lower a Specific Absorption Rate (SRA) value.

## Description

### Technical Field

The disclosure relates to the technical field of mobile wireless communication systems, and in particular to a data card antenna and a construction method thereof.

### Background

With a rapid development of global telecommunication markets, 3G/4G network has been widely prompted. However, since a telecommunication market in each region develops unbalanced, different markets need to be covered by different networks, and need different combinations of modes or different combinations of frequency bands. Terminal equipment manufacturers expect to realize all combinations of modes and frequency bands to meet different requirements of each operator. Therefore, terminal equipments require chips and circuits to support different combinations of modes and frequency bands, and also require antennas to cover all frequency bands. In addition, in order to strictly control a radiation hurt to human bodies from the mobile terminal's electromagnetic waves, operators have higher and higher requirements on a Specific Absorption Rate (SAR) index. Specifically, a lower SAR value is expected.

According to market demand, miniaturization is a tendency for mobile terminals. For operators, the above two requirements of mobile terminals just are the main technical problems of mobile terminals, which are: wide working bandwidth, low SAR value. However, in the related art, data card widely adopts internal antennas such as monopole antenna, Invert F Antenna (IFA) and Plane Invert F Antenna (PIFA). Generally, these types of antennas are located at the tail end of a data card, forming a radiator together with a Print Circuit Board (PCB). The type of antenna and construction method that adopted in the related art, the antenna occupies a large space, with a narrower bandwidth and a higher SAR value.

### Summary

A data card antenna and a construction method thereof are provided by embodiment of the disclosure, so as to at least resolve the technical problems of large space occupied by antenna, narrower antenna bandwidth and higher SAR value in the related art.

In order to achieve the purpose of the disclosure, a data card antenna is provided according to an embodiment of the disclosure, comprising: a Universal Serial Bus (USB) connector and a Printed Circuit Board (PCB), wherein a semi-closed gap is provided at one end of the PCB close to the USB connector, a feeding point and a metal radiator covering the semi-closed gap and electrically connected to the feeding point are provided in the semi-closed gap.

Optionally, the semi-closed gap is in a semi-closed U shape, semi-closed triangular shape or semi-closed rhombus shape.

A data card is further provided according to an embodiment of the disclosure, comprising: a data card antenna, wherein the data card antenna comprises a USB connector and a Printed Circuit Board (PCB), a semi-closed gap is provided at one end of the PCB close to the USB connector, a feeding point and a metal radiator covering the semi-closed gap and electrically connected to the feeding point are provided in the semi-closed gap.

A construction method for a data card antenna is further provided according to an embodiment of the disclosure, comprising:
providing a semi-closed gap at one end of a Printed Circuit Board (PCB) of a data card close to a USB connector;
providing a feeding point in the semi-closed gap;
providing a metal radiator covering the semi-closed gap; and
connecting the feeding point to the metal radiator.

Optionally, providing the semi-closed gap at one end of the PCB of the data card close to the USB connector comprises:
providing the semi-closed gap to be in a semi-closed U shape, semi-closed triangular shape or semi-closed rhombus shape.

From the above, it can be known that the disclosure provides a semi-closed gap at one end of a PCB close to a USB connector, covers the semi-closed gap using a metal radiator, and provides a feeding point in the semi-closed gap to connect with the metal radiator. The data card antenna provided in the embodiment of the disclosure can improve antenna bandwidth by making full use of the mutual effect between the PCB and the radiator, and reduces the space occupied. In addition, the antenna close to an end of the USB connector can transfer partial radiation energy to a computer connected to the USB connector through electromagnetic wave, thereby reducing the SAR value.

### Brief Description of the Drawings

Fig. 1 is a structure diagram of an embodiment of a data card antenna according to the disclosure;
Fig. 2 is a structure diagram of the curve of an reflection coefficient S11 of a function of frequency when a data card antenna works according to an embodiment of the data card antenna according to the disclosure;
Fig. 3 is test data of SAR according to an embodiment of the data card antenna according to the disclosure; and
Fig. 4 is a flowchart of an embodiment of the construction of a data card antenna according to the disclosure.

The implementation of the purpose of the disclosure, the function features and advantages thereof are described below in further detail in conjunction with embodiments by reference to accompanying drawings.

### Detailed Description of the Embodiments

It should be understood that specific embodiments described below are only to illustrate the disclosure but to limit the disclosure.

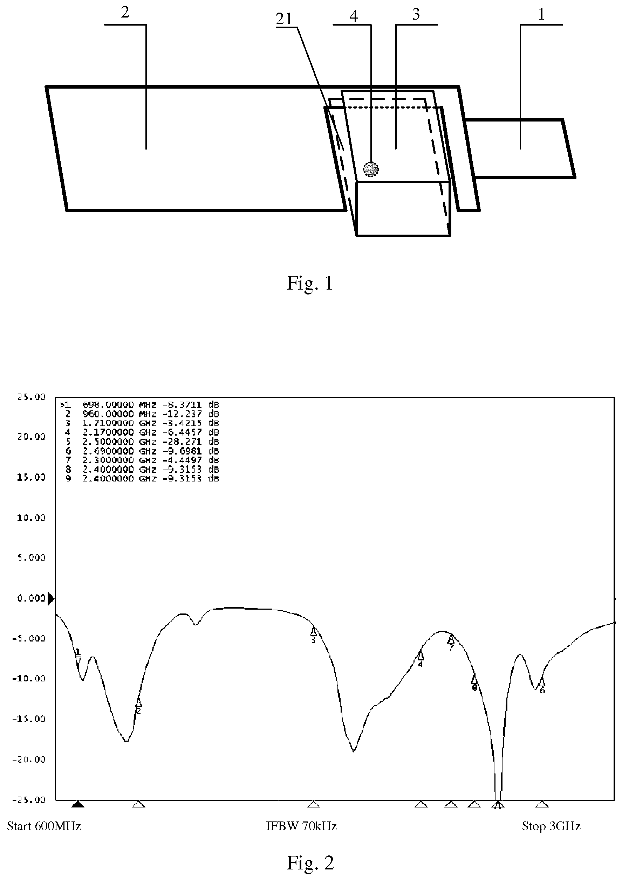

The embodiment of the disclosure provides a data card antenna. Referring to Fig. 1, the data card antenna comprises a USB connector 1 and a PCB 2. A semi-closed gap 21 is provided at one end of the PCB 2 close to the USB connector 1. A feeding point 4, and a metal radiator 3 covering the semi-closed gap 21 and electrically connected to the feeding point 4 are provided in the semi-closed gap 21.

In the embodiment of the disclosure, the semi-closed gap 21 is covered by the metal radiator 3. The feeding point 4 is provided in the semi-closed gap 21 to connect to the metal radiator 3, so that the metal radiator 3, the feeding point 4 and the PCB 2 form an antenna unit. The PCB 2 and the metal radiator 3 may be mutually coupled and interact with each other to improve antenna bandwidth. In addition, since the semi-closed gap is directly opened on the PCB 2, the feeding point 4 and the metal radiator 3 are provided in the gap 21, the space occupied by the antenna is relatively smaller. Moreover, that the antenna is close to an end of the USB connector 1 may transfer partial radiation energy to a computer connected to the USB connector 1 through electromagnetic wave, thereby reducing the SAR value.

In the embodiment of the disclosure, the semi-closed gap 21 is a semi-closed shape. Besides the U shape shown in Fig. 1, the semi-closed gap 21 also may be provided as a semi-closed triangular shape, a semi-closed rhombus shape and other shapes, and the size of the semi-closed gap 21 may just meet the requirement of electrical length. Besides the position of the feeding point 4 shown in Fig. 1, the feeding point 4 also may be provided at other positions in the semi-closed gap 21. The metal radiator 3 covers the semi-closed gap 21, and the shape of the metal radiator 3 adapts to the shape of the semi-closed gap 21; the metal radiator 3 is electrically connected with the feeding point 4 in a contact manner.

As shown in Fig. 2, which is a schematic diagram of the curve of an reflection coefficient S11 of a function of frequency when a data card antenna works according to an embodiment of the disclosure, the horizontal coordinate represents frequency F (MHz) and the longitudinal coordinate represents reflection coefficient S11 (dB). From Fig. 2, it can be seen that the working bandwidth of the antenna provided in the embodiment of the disclosure increases from 698MHz to 2700MHz and the antenna has a very wide working frequency range when compared to one in the related art. This meets the working bandwidth requirements of all frequency bands of 2G/3G/Long Term Evolution (LTE).

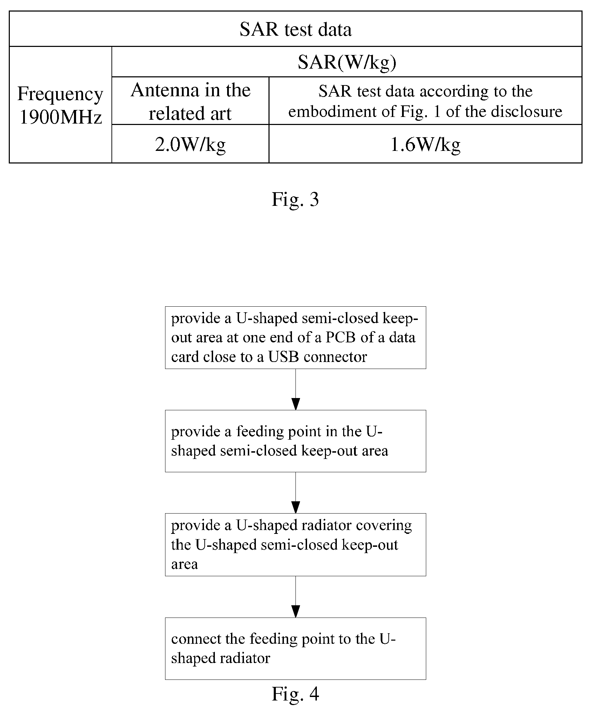

Fig. 3 is the SAR test data of a data card antenna according to Fig. 1 of the embodiment of the disclosure. As shown in Fig. 3, the antenna shown in Fig. 1 of the embodiment of the disclosure has an SAR value of 1.6W/kg at 1900MHz, which is reduced by 25% when compared to one in the related art.

The embodiment of the disclosure also provides a data card, which comprises a data card antenna. The data card antenna is the data card antenna described in the above embodiment, comprising: a USB connector 1 and a PCB 2, a semi-closed gap 21 is provided at one end of the PCB 2 close to the USB connector 1, a feeding point 4 and a metal radiator 3 covering the semi-closed gap 21 and electrically connected to the feeding point 4 are provided in the semi-closed gap. With the data card antenna described above, the data card in the embodiment of the disclosure has a wider working bandwidth, a smaller volume and a lower SAR value.

The embodiment of the disclosure also provides a construction method for a data card antenna, which as shown in Fig. 4 comprises the following steps:
S10: providing a semi-closed gap at one end of a PCB of a data card close to a USB connector. Taking Fig. 1 for example, a semi-closed gap 21 is provided at one end of the PCB 2 close to the USB connector 1. In the embodiment of the disclosure, the semi-closed gap 21 is a semi-closed shape, besides the U shape shown in Fig. 1, the semi-closed gap 21 also may be provided as a semi-closed triangular shape, a semi-closed rhombus shape and other shapes,
S20: providing a feeding point in the semi-closed gap; besides the position shown in Fig. 1, the feeding point 4 also may be provided at other positions in the semi-closed gap 21. The metal radiator 3 covers the semi-closed gap 21, and the metal radiator 3 is electrically connected with the feeding point 4 in a contact manner.
S30: providing a metal radiator covering the semi-closed gap; in the embodiment of the disclosure, the shape of the metal radiator 3 adapts to the shape of semi-closed gap 21 and the size of the semi-closed gap 21 may just meet the requirement of electrical length.
S40: connecting the feeding point to the metal radiator. The metal radiator 3 covers the semi-closed gap 21 and is electrically connected with the feeding point 4 in a contact manner.

In a preferred embodiment, in S10, the semi-closed gap may be provided to be in a semi-closed U shape, semi-closed triangular shape or semi-closed rhombus shape, and of course to be other shapes.

From the above it can be known that the disclosure designs a semi-closed gap at one end of a PCB close to a USB connector, covers the gap using a metal radiator, and provides a feeding point in the semi-closed gap to connect with the metal radiator. Compare with the related art, the data card antenna provided in the embodiment of the disclosure can improve antenna bandwidth by making full use of the interaction between the PCB and the radiator, and reduces the space occupied by the antenna. In addition, the end of the antenna close to the USB connector can transfer partial radiation energy to a computer connected to the USB connector through electromagnetic wave, thereby reducing the SAR value.

The above are only the preferred embodiments of the disclosure and are not intended to limit the patent scope of the disclosure. Any equivalent structures or equivalent flow modifications made according to the description and the accompanying drawings of the disclosure, or any equivalent structures or equivalent flow modifications applied in other relevant technical fields directly or indirectly are intended to be included in the patent protection scope of the disclosure.

## Claims

1. A data card antenna, comprising: a Universal Serial Bus, USB, connector and a Printed Circuit Board, PCB, wherein a semi-closed gap is provided at one end of the PCB close to the USB connector, a feeding point and a metal radiator covering the semi-closed gap and electrically connected to the feeding point are provided in the semi-closed gap.

2. The data card antenna as claimed in claim 1, wherein the semi-closed gap is in a semi-closed U shape, semi-closed triangular shape or semi-closed rhombus shape.

3. A data card, comprising a data card antenna, wherein the data card antenna comprises a Universal Serial Bus, USB, connector and a Printed Circuit Board, PCB, a semi-closed gap is provided at one end of the PCB close to the USB connector, a feeding point and a metal radiator covering the semi-closed gap and electrically connected to the feeding point are provided in the semi-closed gap.

4. The data card as claimed in claim 1, wherein the semi-closed gap is in a semi-closed U shape, semi-closed triangular shape or semi-closed rhombus shape.

5. A construction method for a data card antenna, comprising:
providing a semi-closed gap at one end of a Printed Circuit Board (PCB) of a data card close to a USB connector;
providing a feeding point in the semi-closed gap;
providing a metal radiator covering the semi-closed gap; and
connecting the feeding point to the metal radiator.

6. The method as claimed in claim 5, wherein providing the semi-closed gap at one end of the PCB of the data card close to the USB connector comprises:
providing the semi-closed gap which is in a semi-closed U shape, semi-closed triangular shape or semi-closed rhombus shape.
